Europäisches Patentamt

European Patent Office

Office européen des brevets

(19)

(11) EP 0 567 406 B1

(12) FASCICULE DE BREVET EUROPEEN

(45) Date de publication et mention
de la délivrance du brevet:
**31.01.1996 Bulletin 1996/05**

(51) Int Cl.⁶: **H01S 3/085**

(21) Numéro de dépôt: **93401046.3**

(22) Date de dépôt: **22.04.1993**

(54) **Structure laser à rétroaction répartie**

Laser mit verteilter Rückkopplung

Distributed feedback laser

(84) Etats contractants désignés:
**DE GB**

(30) Priorité: **24.04.1992 FR 9205076**

(43) Date de publication de la demande:
**27.10.1993 Bulletin 1993/43**

(73) Titulaire: **FRANCE TELECOM**
**F-75015 Paris (FR)**

(72) Inventeurs:
• **Talneau, Anne Juliette**
 **F-75005 Paris (FR)**
• **Charil, Josette Claire**
 **F-92190 Meudon (FR)**

(74) Mandataire: **Martin, Jean-Jacques et al**
**F-75116 Paris (FR)**

(56) Documents cités:
 **EP-A- 0 321 328      EP-A- 0 390 614**
 **EP-A- 0 461 632**

• **IEEE PHOTONICS TECHNOLOGY LETTERS**
 **vol. 2, no. 6, Juin 1990, NEW YORK US,pages**
 **388 - 390;G. MORTHIER ET AL 'A new DFB laser**
 **diode with reduced spatial hole burning'**
• **PATENT ABSTRACTS OF JAPAN vol. 16, no. 38**
 **(E-1161)30 Janvier 1992;& JP-A-03248492**
• **IEEE JOURNAL OF QUANTUM ELECTRONICS.**
 **vol. 24, no. 10, Octobre 1988, NEW YORK**
 **US,pages 2017 - 2033;YOSHIAKI NAKANO ET**
 **AL 'Analysis , design, and fabrication of**
 **GaAlAs/GaAs DFB lasers with modulated**
 **stripe width structure for complete single**
 **longitudinal mode oscillation'**
• **PATENT ABSTRACTS OF JAPAN vol. 12, no.**
 **200 (E-619)9 Juin 1988;& JP-A-63000186**

**Description**

La présente invention concerne le domaine des structures laser à semi-conducteurs et plus particulièrement une structure laser à rétroaction répartie (DFB).

Dans le domaine des télécommunications optiques, on cherche à augmenter le débit de données véhiculées par la lumière et l'un des moyens pour y parvenir consiste à utiliser des sources lumineuses de plus en plus monochromatiques. Les diodes laser à rétroaction répartie présentent une faible largeur spectrale et sont apparues comme des sources lumineuses privilégiées.

Dans ce type de diode laser, la rétroaction lumineuse nécessaire au phénomène laser provient de la rétrodiffusion de Bragg résultant d'une perturbation périodique de l'indice de réfraction d'une région de la structure de la diode dans laquelle l'onde lumineuse se propage. On réalise pour ce faire un réseau de diffraction comportant des motifs répartis le long de la structure, ces motifs s'étendant généralement transversalement à la direction de propagation de la lumière.

Dans les diodes laser à rétroaction répartie conventionnelles, le réseau de diffraction réalise un couplage entre de la lumière se propageant dans un sens (ou onde aller) et de la lumière se propageant en sens opposé (onde retour) d'amplitude constante.

A fort niveau de puissance émise, on observe des instabilités dans le fonctionnement des diodes laser conventionnelles qui se traduisent par l'apparition de modes secondaires longitudinaux se superposant au mode principal, avec pour inconvénient d'altérer les performances de ces diodes laser, notamment par élargissement du spectre d'émission et dégradation de la linéarité de la réponse de la puissance émise en fonction du courant injecté. Ce phénomène d'instabilités, connu sous l'expression "Hole-Burning" d'origine anglo-saxonne, résulte principalement d'une inhomogénéité du champ électrique de l'onde lumineuse le long de la structure.

Diverses structures ont été proposées pour améliorer les performances des diodes laser conventionnelles, et limiter le phénomène de "Hole-Burning".

OGITA et al., dans l'article "Long-cavity, multiple-phase-shift, distributed feedback laser for linewidth narrowing" Electronics Letters Vol. 25, N° 10, pages 629-630, 1989, propose de réaliser plusieurs sauts de phase le long du réseau. Cependant, OGITA restreint son étude à des structures laser de courte longueur, environ 400 µm, puisque les phénomènes d'instabilités dûs au "Hole-Burning" tendent à augmenter avec la longueur de la structure. Or il paraît avantageux de réaliser des structures de plus grande longueur, car la monochromaticité du spectre émis s'améliore notablement lorsque la longueur de la structure augmente.

Une structure d'une longueur de 1,2 mm a été réalisée par OKAI et al., dans l'article "Corrugation-Pitch-Modulated Phase-Shifted DFB Laser", IEEE Photonics Technology Letters, Vol. 1, N° 8, August 1989. OKAI propose de moduler la période du réseau pour garantir un fonctionnement stable. Toutefois, si le phénomène de "Hole-Burning" est considérablement réduit, il n'est pas complètement éliminé.

D'autres auteurs ont proposé des approches différentes face à ce problème de "Hole-Burning". Parmi ceux-ci, MORTHIER et al, dans l'article "A New DFB-Laser Diode with Reduced Spatial Hole-Burning", IEEE Photonics Technology Letters, Vol. 2, N° 6, June 1990, démontre par des considérations théoriques qu'il est possible d'améliorer la répartition du champ électrique de l'onde lumineuse dans la structure et de réduire ainsi le phénomène de "Hole-Burning" en réalisant une variation de l'amplitude de couplage, de sorte que le couplage soit minimum au centre de la structure.

MORTHIER limite cependant son étude à une structure de faible longueur, environ 300 µm, délimitée par des faces traitées anti-reflet. MORTHIER constate que la modulation du couplage s'accompagne d'un déphasage de l'onde lumineuse dans la structure qui empêche le laser d'osciller à la fréquence de Bragg, avec l'inconvénient de conduire à une faible réjection des modes secondaires. L'auteur ne propose ni ne suggère de solutions pour tenter de remédier à cet inconvénient.

Un objet de l'invention est de proposer une structure laser améliorée, remédiant aux inconvénients précités.

L'invention propose pour cela une structure laser à semi-conducteur à rétroaction répartie (DFB), du type à zone de guidage latéral par l'indice, comportant un réseau de diffraction déphasé s'étendant entre deux régions d'extrémité le long d'une direction de propagation de la lumière, pour exercer un couplage au sein de la,structure entre la lumière se propageant dans un sens et la lumière se propageant dans le sens opposé, le réseau de diffraction étant adapté à réaliser un couplage d'amplitude variable le long de la structure entre lesdites régions d'extrémité, caractérisée en ce que la largeur de la zone de guidage varie, de sorte que le déphasage induit par cette variation de largeur compense le déphasage induit par la variation de l'amplitude de couplage.

Selon une caractéristique avantageuse de l'invention, le réseau de diffraction est adapté pour définir un couplage extrémum au niveau desdites régions d'extrémité.

De préférence, lesdites régions d'extrémité du réseau de diffraction coïncident sensiblement avec des faces de la structure.

Dans un mode de réalisation, l'extrémum est un minimum.

Dans un autre mode de réalisation, l'extrémum est un maximum.

Dans ce dernier cas, il est avantageux de faire croître la largeur de la zone de guidage à partir desdites régions d'extrémité du réseau de diffraction vers le centre de la structure.

De préférence, la structure comporte des faces clivées réfléchissantes, dont le coefficient de réflexion est avantageusement voisin de 30 %.

De préférence également, l'amplitude de couplage varie selon une fonction cosinus.

De préférence, la longueur de la structure est supérieure ou égale à 600 $\mu m$.

La structure selon l'invention comprend avantageusement une zone active formée par un empilement de couches élémentaires en matériaux alternativement ternaires et quaternaires de façon à définir une zone multipuits quantiques (MQW).

De préférence, la structure est une structure dite à ruban enterré.

D'autres caractéristiques et avantages de l'invention apparaîtront à la lecture de la description détaillée qui va suivre d'un mode de réalisation non limitatif de l'invention et à l'examen du dessin annexé sur lequel :

- la figure 1 est une vue en perspective, schématique, avec arrachement partiel, montrant le réseau de diffraction d'une structure de diode laser conforme à l'invention,

- la figure 1A représente de façon schématique, en coupe, le détail de la constitution de la zone active d'une structure laser conforme à un mode particulier de réalisation de l'invention,

- la figure 2 représente de façon schématique des franges d'interférences servant à la réalisation du réseau de diffraction,

- la figure 2A montre la variation de l'amplitude de couplage dans une structure conforme à un premier mode de réalisation de l'invention, dont le réseau de diffraction a été obtenu à partir de franges d'interférences telles que représentées sur la figure 2,

- la figure 2B représente de façon schématique l'allure des motifs d'un réseau de diffraction réalisé par gravure chimique, en coupe longitudinale,

- la figure 2C montre la variation de l'amplitude de couplage dans une structure conforme à un deuxième mode de réalisation de l'invention, obtenue à partir de franges d'interférences telles que représentées sur la figure 2,

- la figure 3 représente des courbes montrant l'évolution de la puissance émise en fonction du courant injecté ainsi que le rendement quantique différentiel externe par face, en fonction du courant injecté, pour une structure dont le réseau de diffraction présente des motifs de longueur variable et de largeur constante,

- la figure 4 montre la variation d'indice effectif le long de la structure, résultant d'une variation de longueur des motifs du réseau,

- les figures 5A à 5C représentent des spectres obtenus à partir de structures de diodes laser, dont le réseau de diffraction présente des motifs de longueur variable et de largeur constante,

- la figure 6 montre en vue de dessus l'allure générale d'un réseau de diffraction, présentant des motifs de longueur constante et de largeur variable,

- la figure 7 illustre schématiquement la variation d'indice effectif qui résulte d'une variation de largeur de ruban conforme à celle représentée sur la figure 6,

- la figure 8 montre en vue de dessus l'allure générale d'un réseau de diffraction conforme à l'invention, présentant des motifs de longueur et de largeur variables,

- les figures 9A et 9B témoignent de l'écart entre le mode principal et les modes secondaires pour des structures de diodes laser dont les motifs du réseau de diffraction sont de longueur variable, et dont largeur est respectivement constante et variable.

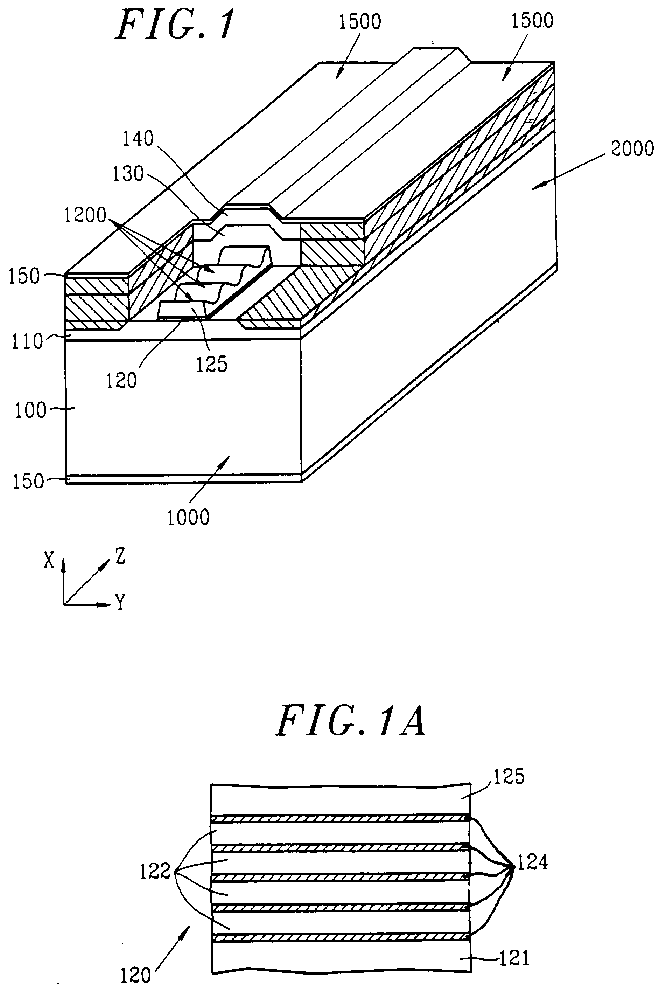

On a représenté sur la figure 1, de façon schématique, une structure laser conforme à l'invention, associée à un repère orthogonal XYZ.

Dans toute la suite de la description, il sera fait référence à l'axe Z en tant qu'axe longitudinal, à l'axe Y en tant qu'axe transverse horizontal et à l'axe X en tant qu'axe transverse vertical, et les termes épaisseur, largeur, longueur, se référeront respectivement à des distances mesurées le long des axes X, Y, Z.

Une structure de diode laser à rétroaction répartie et du type à zone de guidage latéral par l'indice, conforme à l'invention, représentée sur la figure 1, est réalisée en utilisant des techniques connues de croissance par épitaxie en phase vapeur (MOVPE en anglais). On commence par faire croître successivement sur un substrat 100 en phosphure d'indium InP dopé n, une couche de confinement inférieure 110 en phosphure d'indium InP dopé n, typiquement avec une épaisseur de l'ordre de 2 micromètres, puis un ensemble de couches élémentaires constituant une zone active 120, susceptible d'amplifier la lumière. De préférence, la zone active 120 est formée par un empilement de couches élémentaires alternativement en matériau ternaire et en matériau quaternaire, aptes à former un ensemble de barrières et puits quantiques (MQW en anglais).

Selon la longueur d'onde que l'on recherche pour l'émission laser, divers paramètres de la zone active 120 seront adaptés au choix de l'homme de l'art, par exemple le nombre de couches élémentaires, la composition précise des matériaux ternaires et quaternaires, l'épaisseur des couches élémentaires, etc...

Ainsi, dans un exemple de réalisation non limitatif de l'invention, pour une longueur d'onde souhaitée de 1,5 micromètres environ, on dépose par épitaxie sur la couche de confinement inférieure 110, comme illustré schématiquement sur la figure 1A, une première couche élémentaire 121 de 1250 Å d'épaisseur en matériau quaternaire $Ga_{0,42} In_{0,58} As_{0,89} P_{0,11}$, puis cinq couches élémentaires 124 en matériau ternaire $Ga_{0,47} In_{0,53} As$ de 30 Å d'épaisseur en alternance avec des couches élémentaires 122 de matériau quaternaire $Ga_{0,42} In_{0,58} As_{0,89} P_{0,11}$ de 150 Å d'épaisseur.

Ensuite on dépose sur la dernière couche élémentaire 124 épitaxiée une couche 125 de composition et d'épaisseur identique à la couche 121 que l'on recouvre d'une couche de résine photosensible en vue de graver un réseau de diffraction.

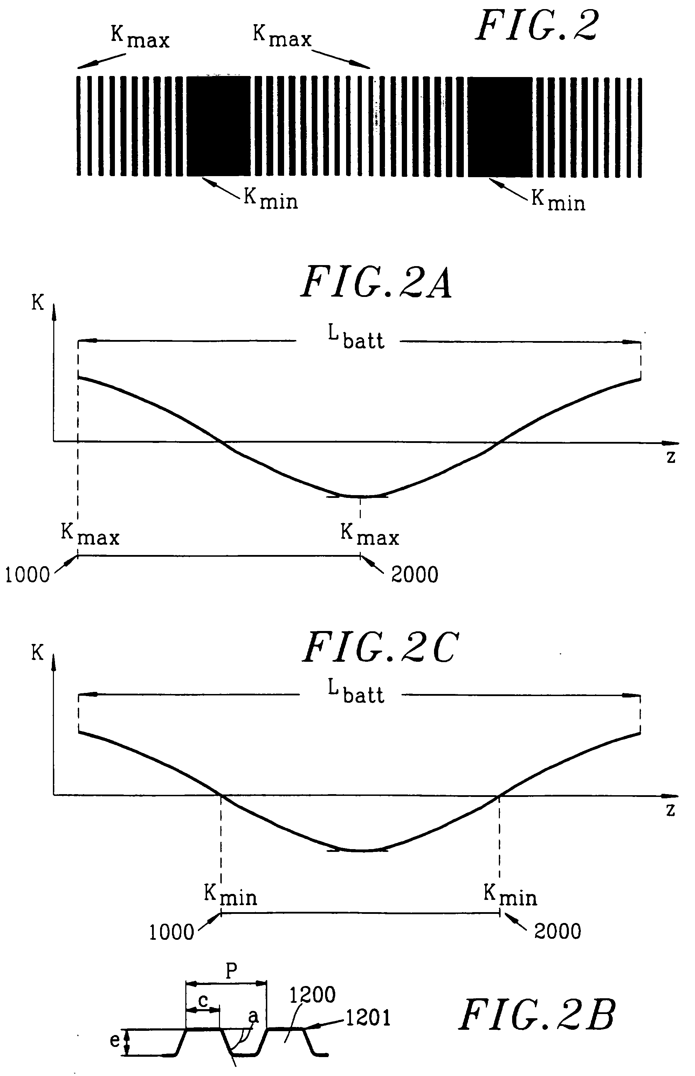

De préférence, on insole cette résine photosensible avec deux systèmes de franges d'interférences de périodes L + dL/2 et L - dL/2 légèrement différentes, réalisant ainsi un moiré semblable à celui représenté à titre d'illustration sur la figure 2.

Les zones noires référencées $K_{min}$ sont celles où les motifs 1200 du réseau de diffraction auront une longueur minimale, et les zones claires $K_{max}$ seront celles où les motifs du réseau auront une longueur maximale.

Il faut bien noter que la longueur d'un motif est la dimension de celui-ci, mesurée parallèlement à la direction de propagation Z de la lumière dans la structure, comme cela sera précisé dans la description en référence à la figure 2B. La variation de l'amplitude de couplage K qui résulte de la modulation de la longueur des motifs 1200 du réseau de diffraction est illustrée sur la figure 2A, et peut être décrite par une fonction cosinus : $K = K_o$. cos ($2 * pi * z / L_{batt}$) avec $L_{batt} = L^2/dL$, $K_o$ étant une constante dont la valeur sera précisée dans la suite.

Après insolation, le réseau de diffraction est gravé par voie chimique selon des méthodes connues de photolithographie.

Comme on peut le remarquer à l'examen de la figure 1, les motifs 1200 du réseau de diffraction sont orientés transversalement à la direction de propagation Z de l'onde lumineuse dans la structure laser. Le vecteur champ électrique de l'onde lumineuse s'étend parallèlement à l'axe Y, dans le mode recherché pour l'oscillation laser.

Ensuite il est procédé à la gravure du réseau gravé sur la couche 125 et de la zone active 120 pour former un ruban.

De préférence, ce ruban est gravé à l'aide d'un faisceau d'ions réactifs (RIBE en anglais) en interposant un masque de lithographie adéquat entre la structure à graver et la source d'ions.

Le ruban formé présente de préférence, conformément à une caractéristique de l'invention, une largeur variable comme cela sera précisé dans la suite.

La largeur moyenne du ruban ainsi formé est de préférence de l'ordre de 1,7 micromètres, ce qui assure un fonctionnement monomode du laser.

Après gravure du ruban, on effectue une deuxième étape d'épitaxie et l'on fait croître une couche 130 de confinement supérieure en phosphure d'indium InP dopée p d'environ 1,5 micromètres d'épaisseur, puis une couche 140 de matériau ternaire GaInAs fortement dopée p, d'environ 0,5 micromètres d'épaisseur.

On réalise ensuite des contacts ohmiques 150 par métallisation, selon des méthodes connues et on limite le courant de fuite par implantation protonique dans des régions 1500 situées de part et d'autre du ruban, indiquées par des hachures sur la figure 1.

On obtient ainsi une structure dite à ruban enterré, le ruban constituant zone de guidage latéral par l'indice dans l'exemple de réalisation décrit.

En effet, la lumière est confinée dans le ruban latéralement, c'est-à-dire entre les deux faces du ruban s'étendant dans la direction de l'axe longitudinal Z, sensiblement parallèlement à la direction verticale X, par la variation d'indice entre l'indice des différentes couches constituant la zone active et le réseau de diffraction et l'indice de la couche de confinement supérieure 130, moins élevé.

Enfin, on réalise les faces d'extrémité 1000 et 2000 de la structure laser par clivage, la longueur de la structure étant avantageusement supérieure à 600 µm.

De préférence, les faces d'extrémité 1000 et 2000 présentent un coefficient de réflexion de l'ordre de 30 %.

Ainsi, une partie importante de la lumière sortant par une face de la structure est réfléchie vers l'intérieur de celle-ci et participe à la rétroaction nécessaire au phénomène laser de sorte que le courant de seuil Is est réduit.

Le cas échéant, les faces d'extrémité 1000 et 2000 sont traitées anti-reflet, ce qui, outre le fait de nécessiter une étape technologique supplémentaire augmente le courant de seuil Is par rapport à une structure à faces clivées réfléchissantes.

En contrepartie, la puissance lumineuse émise est plus importante, et d'une façon générale, le choix de traiter anti-reflet ou non les faces d'extrémité découlera d'un compromis à l'égard de l'utilisation à laquelle le laser est destiné, selon que celle-ci privilégie la puissance émise ou le faible courant de seuil.

Conformément à l'invention et comme cela va être précisé dans la suite, les motifs 1200 du réseau de diffraction ont une longueur déterminée au niveau des régions d'extrémité longitudinales du réseau de diffraction, qui coïncident de préférence avec des faces d'extrémité 1000 et 2000 de la structure, de telle sorte que le couplage entre l'onde aller et l'onde retour dans la structure soit extrémum au niveau desdites régions d'extrémité longitudinales du réseau de diffraction. L'allure des motifs obtenus par gravure chimique est représentée en coupe longitudinale schématiquement sur la figure 2B.

Les caractéristiques géométriques du réseau de diffraction, notamment la profondeur des motifs 1200 et le pas du réseau sont choisies en fonction du couplage K désiré, la profondeur des motifs du réseau, c'est-à-dire leur dimension dans la direction verticale X, variant de préférence entre 30 et 70 nm (300 et 700 Å). Le pas P du réseau correspond de préférence à (longueur d'onde émise dans l'air) / 2 . $n_{eff}$ où $n_{eff}$ sera précisé dans la suite. L'angle a vaut 54° environ, étant défini par les plans (111)A que fait apparaître la gravure chimique.

Le couplage réalisé par un motif 1200 du réseau dépend de la longueur c de son sommet 1201 en forme de plateau, ainsi que de la profondeur e. D'une façon générale, le couplage passe par un maximum pour une longueur de plateau c' déterminée, pour chaque profondeur e donnée, et ensuite décroît pour des longueurs de plateau inférieures ou supérieures à cette valeur.

Le réseau de diffraction est qualifié de déphasé car l'onde lumineuse se propageant le long de celui-ci subit un déphasage.

Pour un fonctionnement optimal du laser, le déphasage total subi par l'onde lumineuse le long du réseau de diffraction vaut pi, et la fréquence à laquelle se propage l'onde lumineuse est alors appelée fréquence de Bragg.

Dans un premier mode de réalisation préféré de l'invention, illustré sur la figure 2A, le réseau de diffraction s'étend sur toute la longueur de la structure et les faces d'extrémité 1000, 2000 de celle-ci sont positionnées par rapport aux franges de la figure 2 de telle sorte que la longueur des plateaux 1201 du réseau soit égale à c' au niveau des faces d'extrémité de la cavité. Il en résulte que le couplage entre l'onde aller et l'onde retour est maximum au niveau de celles-ci, et, corrélativement, le couplage est minimum dans la région centrale de la structure. Il découle de cette configuration plusieurs avantages, dont celui de limiter l'effet du déphasage de l'onde lumineuse à la réflexion sur les faces, puisque la proportion de l'onde lumineuse atteignant les faces d'extrémité est réduite de par la rétrodiffusion plus importante à ce niveau ; il n'est donc pas nécessaire de traiter anti-reflet les faces d'extrémité 1000 et 2000.

Par ailleurs, en réalisant un couplage d'amplitude faible dans la région centrale de la structure, là où le champ électrique de l'onde lumineuse est particulièrement élevé, on rend ce dernier plus homogène le long de la structure et on diminue les phénomènes d'instabilités dûs au "Hole-Burning".

Une structure selon l'invention permet ainsi d'avoir un fonctionnement monomode à forte puissance (de l'ordre de 80 mW environ) tout en obtenant une bonne linéarité de la puissance émise en fonction de l'intensité du courant injecté.

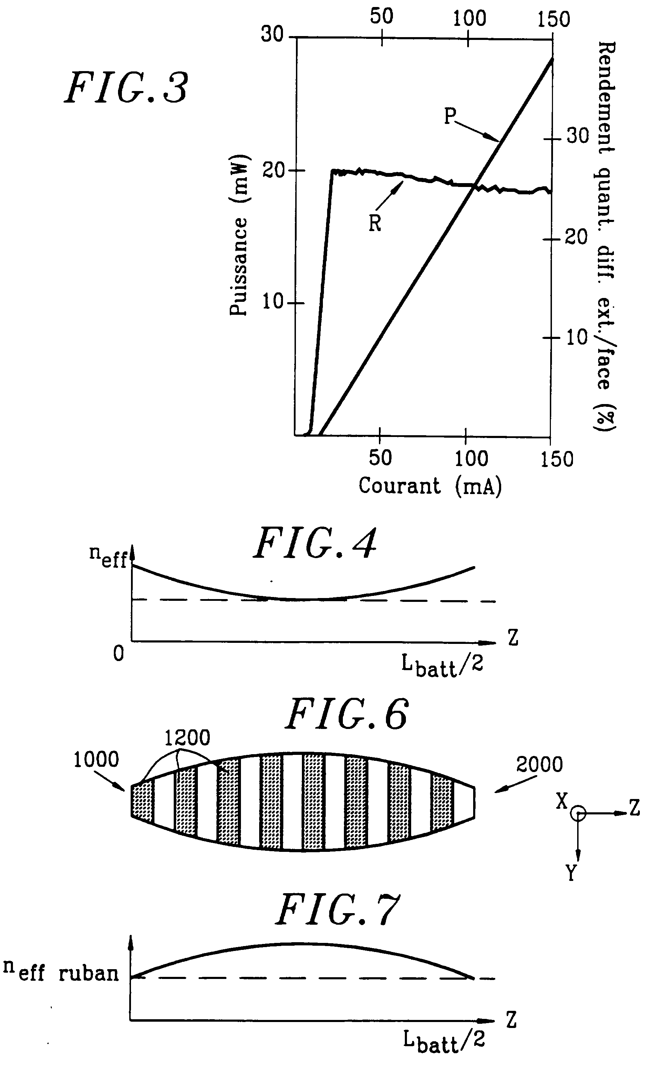

On a représenté sur la figure 3 une courbe expérimentale P montrant l'évolution de la puissance émise (en ordonnées sur l'échelle de gauche) en fonction du courant injecté (en abscisse) et l'on peut constater à l'examen de cette figure la très bonne linéarité obtenue avec une structure conforme à l'invention, pour laquelle l'amplitude de couplage varie conformément à la figure 2A, où $K_o = 80$ cm$^{-1}$ et la longueur 1 de la structure vaut 640 μm.

Par ailleurs, on remarque que la courbe R montrant le rendement quantique différentiel externe par face (en ordonnées sur l'échelle de droite) en fonction du courant injecté (en abscisse) varie peu autour d'une valeur moyenne, de l'ordre de 0,25 mW/mA, ce qui, étant donné la valeur relativement importante de l'amplitude de couplage moyenne $K_m1$ pour cette structure

$$(K_m1 = \int_o^1 K_{(z)}\, d_z = 3.3)$$

indique à l'homme de l'art que le phénomène de "Hole-Burning" est absent.

En effet, on rencontre un fort phénomène de "Hole-Burning" pour des structures de diodes laser conventionnelles d'amplitude de couplage moyenne $K_m1$ comparable et dont l'amplitude de couplage est constante.

On préfèrera que l'écart de longueur des motifs du réseau au niveau des faces d'extrémité et dans la région centrale de la structure soit maximal, et dans le cas particulier d'une variation en fonction cosinus, la longueur 1 de la structure sera choisie sensiblement égale à $L_{batt}$ / 2, où $L_{batt}$ a été défini précédemment.

On peut également proposer, dans un deuxième mode de réalisation de l'invention illustré sur la figure 2B, de positionner les franges d'interférences utilisées lors de la gravure du réseau de diffraction de telle manière que les plateaux 1201 aient une longueur différente de c' au niveau des régions d'extrémité du réseau de diffraction, qui coïncident de préférence avec les faces 1000 et 2000 de la structure, et voisine de c' dans la région centrale de celle-ci. On réalise ainsi un couplage maximum au centre et minimum au niveau des régions d'extrémité du réseau. La Demanderesse a constaté qu'alors, de façon inattendue, la réjection des modes secondaires est améliorée car l'écart entre les courants aux seuils des modes principal et secondaire est accru.

Conformément à l'invention, la largeur du ruban varie avec la direction longitudinale Z pour compenser le déphasage induit par la variation de l'amplitude de couplage.

On peut montrer qu'étant données les dimensions suffisamment différentes d'épaisseur et de largeur du ruban, tout se passe comme si l'on pouvait découpler dans les équations décrivant le confinement du champ électrique de l'onde lumineuse et le couplage, ce qui dépend de X (confinement vertical et couplage) et ce qui dépend de Y (confinement latéral), qui est la direction parallèle à l'orientation du champ électrique dans la structure. Le calcul de l'indice effectif $n_{eff}$ de la structure vu par l'onde qui se propage, directement lié au phénomène de couplage entre l'onde aller et l'onde retour ne fait donc intervenir que les variables Z et X.

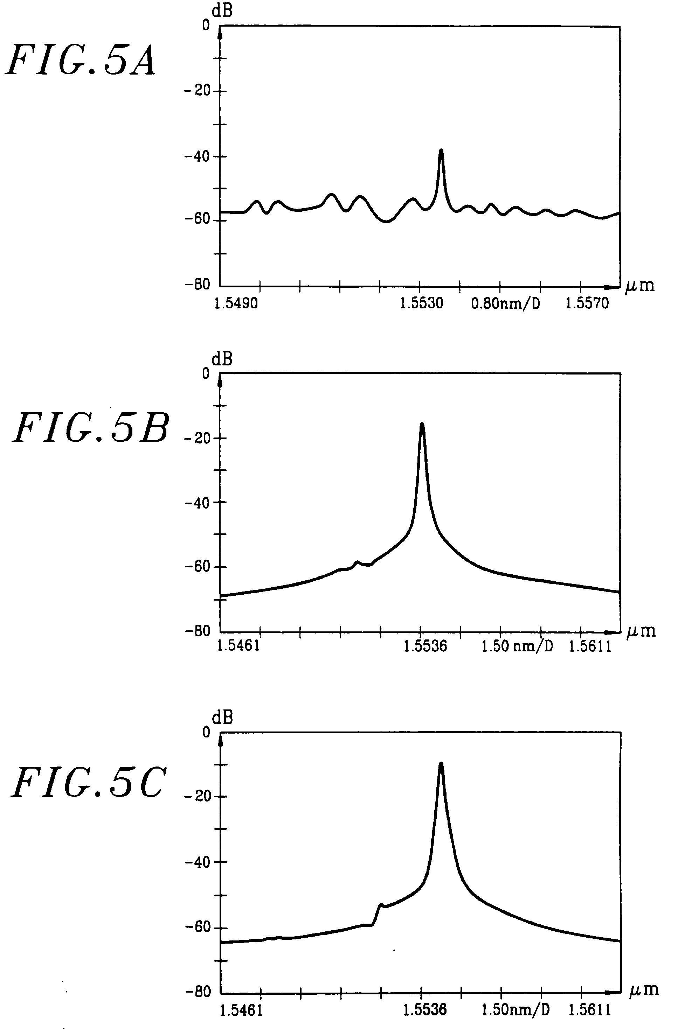

On a représenté sur la figure 4, schématiquement, la variation de l'indice effectif $n_{eff}$ en fonction de la coordonnée longitudinale Z, pour une structure dont les motifs 1200 du réseau de diffraction présentent une longueur donnant un couplage maximum au niveau des faces d'extrémité de la structure et dont la largeur est constante.

Cette variation d'indice effectif s'accompagne d'un déphasage de l'onde lumineuse, qui a pour effet de rendre moins constructives entre elles les interférences des ondes aller et retour dans la structure, avec pour conséquence, comme l'a remarqué Morthier dans son article cité précédemment, d'entraîner une diminution de la réjection des modes secondaires.

Les figures 5A, 5B et 5C correspondent à des spectres d'émission obtenus avec des structures pour lesquelles l'amplitude de couplage est maximale au niveau des régions d'extrémité du réseau de diffraction, mais pour lesquelles la largeur du ruban est constante. Ces spectres sont respectivement obtenus pour des courants d'injection correspondant à 0,9 ls, 4 ls et 20 ls (soit ls voisin de 25 mA). La puissance atteint respectivement 22,5 mW et 78 mW pour les courants d'injection de 4 Is et 20 Is. La longueur du laser est égale à 650 μm. Les deux faces sont traitées anti-reflet et permettent d'interpréter le spectre au voisinage du seuil comme ne résultant que de l'influence du réseau de diffraction, sans contribution des faces. L'homme de l'art remarquera que le spectre observé au voisinage du seuil (figure 5B) ne présente pas la bande d'arrêt ("stop-band" en anglais) caractéristique des structures pour lesquelles il n'y a pas de déphasage induit par une variation d'amplitude de couplage, et pour lesquelles le déphasage induit par le réseau de diffraction vaut donc exactement pi.

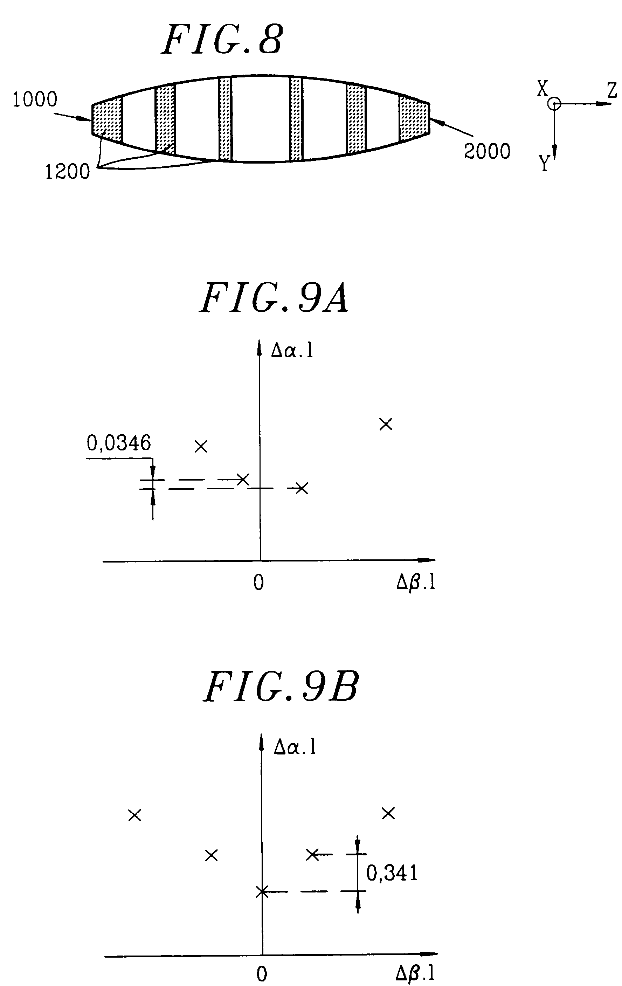

Selon l'invention, la largeur du ruban varie de sorte que la variation d'indice de ruban qui en résulte compense la variation d'indice effectif due à la variation d'amplitude de couplage, ce qui permet à l'onde lumineuse de se propager dans la structure à la fréquence de Bragg, pour laquelle le courant de seuil Is est minimal et la monochromaticité du spectre émis la meilleure. On a représenté, à titre d'illustration, sur la figure 7, la variation d'indice $n_{eff\ ruban}$ en fonction de la coordonnée longitudinale Z, qui résulte d'une variation de largeur de ruban conforme à la figure 6, pour un réseau de diffraction dont les motifs 1200 ont une longueur constante.

L'homme de l'art déduira aisément, à l'examen comparé des figures 4, 6 et 7, qu'au moyen d'un ruban de largeur variable tel que représenté sur la figure 8, il est possible de compenser une variation d'indice effectif $n_{eff}$ obtenue dans le cas d'un réseau de diffraction dont les motifs présentent une longueur variable et une largeur constante par une variation d'indice $n_{eff\ ruban}$ obtenue dans le cas d'un réseau de diffraction dont les motifs présentent une longueur constante et une largeur variable.

La variation de largeur du ruban s'effectue de façon continue ou discontinue, selon les caractéristiques géométriques du réseau de diffraction de la structure. La largeur du ruban sera ainsi comprise de préférence entre 1,5 μm et 1,9 μm, étant bien entendu que ces dimensions peuvent varier au choix de l'homme de l'art.

La compensation du déphasage introduit par la variation de l'amplitude de couplage dans la direction de propagation de l'onde lumineuse à l'aide d'une variation de largeur de ruban améliore considérablement la réjection des modes secondaires, ce que l'homme de l'art pourra aisément apprécier à l'examen comparé des figures 9A et 9B.

On a reporté, respectivement sur ces figures, les résultats d'une simulation concernant une structure dont l'amplitude de couplage est modulée par une fonction cosinus, maximale aux extrémités longitudinales du réseau, la largeur du ruban étant constante, et concernant une structure conforme à l'invention, dont l'amplitude de couplage est modulée de la même façon mais avec une largeur de ruban variable.

On a représenté sur ces figures 9A et 9B en ordonnées une grandeur normalisée $\Delta\alpha$. 1 représentant l'écart entre les seuils des modes principaux et secondaires, et en abscisse une grandeur normalisée $\Delta\beta$. 1 représentant

le décalage en fréquence par rapport à la fréquence de Bragg pour laquelle $\Delta\beta$. 1 = 0.

On remarquera à l'examen de ces figures 9A et 9B qu'une structure conforme à l'invention permet d'obtenir une réjection des modes secondaires dix fois plus importante, dans cet exemple.

Finalement, l'invention permet de réaliser des structures de longueur importante, avantageusement supérieure à 600 μm, qui présentent un fonctionnement stable, une bonne réjection des modes secondaires et une monochromaticité accrue.

La structure à ruban enterré qui vient d'être décrite ne constitue qu'un exemple de structure, non limitatif de l'invention.

En effet, on peut proposer sans sortir du cadre de l'invention, d'autres structures du type à guidage latéral par l'indice. Par exemple, la structure peut être une hétérostructure enterrée du type à double canal planar (DCPBH), une hétérostructure enterrée à gravure du substrat (CSBH), etc...

## Revendications

1. Structure laser à semi-conducteur à rétroaction répartie (DFB), du type à zone de guidage latéral par l'indice, comportant un réseau de diffraction déphasé s'étendant entre deux régions d'extrémité le long d'une direction (Z) de propagation de la lumière, pour exercer un couplage (K) au sein de la structure entre la lumière se propageant dans un sens et la lumière se propageant dans le sens opposé, le réseau de diffraction étant adapté à réaliser un couplage d'amplitude variable le long de la structure entre lesdites régions d'extrémité, caractérisée en ce que la largeur de ladite zone de guidage varie, de sorte que le déphasage induit par cette variation de largeur compense le déphasage induit par la variation de l'amplitude de couplage.

2. Structure laser selon la revendication 1, caractérisée en ce que le réseau de diffraction est adapté pour définir un couplage extrémum au niveau desdites régions d'extrémité.

3. Structure laser selon la revendication 2, caractérisée en ce que le réseau de diffraction est adapté pour définir un couplage minimum au niveau desdites régions d'extrémité.

4. Structure laser selon la revendication 2, caractérisée en ce que le réseau de diffraction est adapté pour définir un couplage maximum au niveau desdites régions d'extrémité.

5. Structure laser selon l'une des revendications 1 à 4, caractérisée en ce que lesdites régions d'extrémité du réseau de diffraction coïncident sensiblement avec des faces (1000, 2000) de la structure.

6. Structure laser selon la revendication 4 ou 5, caractérisée en ce que la largeur de la zone de guidage croît à partir desdites regions d'extrémité du réseau de diffraction vers le centre de la structure.

7. Structure laser selon l'une des revendications 1 à 6, caractérisée en ce que la structure comporte des faces (1000, 2000) clivées réfléchissantes.

8. Structure laser selon la revendication 7, caractérisée en ce que les faces (1000, 2000) clivées ont un coefficient de réflexion de l'ordre de 30 %.

9. Structure laser selon l'une des revendications 1 à 8, caractérisée en ce que l'amplitude de couplage varie selon une fonction cosinus.

10. Structure laser selon l'une des revendications 1 à 9, caractérisée en ce que la longueur de la structure est supérieure ou égale à 600 µm.

11. Structure laser selon l'une des revendications 1 à 10, caractérisée en ce que la variation de l'amplitude de couplage est réalisée par une variation de la longueur des motifs du réseau de diffraction.

12. Structure laser selon l'une des revendications 1 à 11, caractérisée en ce que celle-ci comprend une zone active (120) formée par un empilement de couches élémentaires (121, 122, 124) en matériaux alternativement ternaires et quaternaires de façon à définir une zone multipuits quantiques (MQW).

13. Structure laser selon l'une des revendications 1 à 12, caractérisée en ce que la structure est une structure dite à ruban enterré.

**Patentansprüche**

1. Halbleiterlaseraufbau mit verteilter Rückkopplung (DFB), mit einer Zone seitlicher Führung durch den Index, welcher ein phasenverschobenes Beugungsgitter aufweist, das sich zwischen zwei Endbereichen längs einer Ausbreitungsrichtung (Z) des Lichtes erstreckt, um eine Kopplung (K) im Inneren des Aufbaus zwischen dem sich in einer Richtung ausbreitenden Licht und dem sich in der entgegengesetzten Richtung ausbreitenden Licht zu bewirken, wobei das Beugungsgitter so beschaffen ist, daß entlang des Aufbaus zwischen den besagten Endbereichen eine Kopplung mit variabler Amplitude realisiert wird, dadurch gekennzeichnet, daß sich die Breite der besagten Führungszone ändert, so daß die durch diese Breitenänderung hervorgerufene Phasenverschiebung die durch die Änderung der Kopplungsamplitude hervorgerufene Phasenverschiebung kompensiert.

2. Laseraufbau nach Anspruch 1, dadurch gekennzeichnet, daß das Beugungsgitter so beschaffen ist, daß in den besagten Endbereichen eine extreme Kopplung definiert wird.

3. Laseraufbau nach Anspruch 2, dadurch gekennzeichnet, daß das Beugungsgitter so beschaffen ist, daß in den besagten Endbereichen eine minimale Kopplung definiert wird.

4. Laseraufbau nach Anspruch 2, dadurch gekennzeichnet, daß das Beugungsgitter so beschaffen ist, daß in den besagten Endbereichen eine maximale Kopplung definiert wird.

5. Laseraufbau nach einem der Ansprüche 1 bis 4, dadurch gekennzeichnet, daß die besagten Endbereiche des Beugungsgitters im wesentlichen mit den Seiten (1000, 2000) des Aufbaus zusammenfallen.

6. Laseraufbau nach Anspruch 4 oder 5, dadurch gekennzeichnet, daß die Breite der Führungszone von den besagten Endbereichen des Beugungsgitters zur Mitte des Aufbaus hin zunimmt.

7. Laseraufbau nach einem der Ansprüche 1 bis 6, dadurch gekennzeichnet, daß der Aufbau gespaltene, reflektierende Seiten (1000, 2000) aufweist.

8. Laseraufbau nach Anspruch 7, dadurch gekennzeichnet, daß die gespaltenen Seiten (1000, 2000) einen Reflexionskoeffizient in der Größenordnung von 30% besitzen.

9. Laseraufbau nach einem der Ansprüche 1 bis 8, dadurch gekennzeichnet, daß sich die Kopplungsamplitude gemäß einer Cosinusfunktion ändert.

10. Laseraufbau nach einem der Ansprüche 1 bis 9, dadurch gekennzeichnet, daß die Länge des Aufbaus größer oder gleich 600 µm ist.

11. Laseraufbau nach einem der Ansprüche 1 bis 10, dadurch gekennzeichnet, daß die Änderung der Kopplungsamplitude durch eine Änderung der Länge der Muster des Beugungsgitters realisiert wird.

12. Laseraufbau nach einem der Ansprüche 1 bis 11, dadurch gekennzeichnet, daß er eine aktive Zone (120) umfaßt, welche aus einer Schichtfolge von elementaren Schichten (121, 122, 124) aus abwechselnd ternären und quaternären Materialien besteht, so daß eine Multiquantum-Well-Zone (MQW) definiert wird.

**13.** Laseraufbau nach einem der Ansprüche 1 bis 12, dadurch gekennzeichnet, daß es sich dabei um einen Aufbau mit vergrabenem Streifen handelt.

**Claims**

**1.** A distributed feedback semiconductor laser structure of the type having a guidance zone providing lateral guidance by refractive index variation, including a phase-shifting diffraction grating extending between two end regions along a light propagation direction (Z), for obtaining coupling (K) within the structure between light propagating in one direction and light propagating in the opposite direction, the diffraction grating being adapted to implement coupling of varying amplitude along the structure between said end regions, the structure being characterized in that the width of said guidance zone varies such that the phase shift induced by said variation in width compensates for the phase shift induced by the variation in the coupling amplitude.

**2.** A laser structure according to claim 1, characterized in that the diffraction grating is adapted to define extreme coupling at said extreme regions.

**3.** A laser structure according to claim 2, characterized in the diffraction grating is adapted to define minimum coupling at said extreme regions.

**4.** A laser structure according to claim 2, characterized in that the diffraction grating is adapted to define maximum coupling at said extreme regions.

**5.** A laser structure according to any one of claims 1 to 4, characterized in that said extreme regions of the diffraction grating coincide substantially with faces (1000, 2000) of the structure.

**6.** A laser structure according to claim 4 or 5, characterized in that the width of the guidance zone increases from said extreme regions of the diffraction grating towards the center of the structure.

**7.** A laser structure according to any one of claims 1 to 6, characterized in that the structure includes reflecting cleaved faces (1000, 2000).

**8.** A laser structure according to claim 7, characterized in that the cleaved faces (1000, 2000) have a reflection coefficient of about 30%.

**9.** A laser structure according to any one of claims 1 to 8, characterized in that the coupling amplitude varies in accordance with a cosine function.

**10.** A laser structure according to any one of claims 1 to 9, characterized in that the length of the structure is greater than or equal to 600 μm.

**11.** A laser structure according to any one of claims 1 to 10, characterized in that the coupling amplitude is caused to vary by varying the length of diffraction grating patterns.

**12.** A laser structure according to any one of claims 1 to 11, characterized in that it comprises an active zone (120) formed by a stack of elementary layers (121, 122, 124) of alternating ternary and quaternary materials in such a manner as to define a multiple quantum well zone.

**13.** A laser structure according to any one of claims 1 to 12, characterized in that the structure is a "buried ridge" structure.

## FIG.1

## FIG.1A

*FIG.2*

$K_{max}$  $K_{max}$

$K_{min}$  $K_{min}$

*FIG.2A*

K

$L_{batt}$

z

$K_{max}$  $K_{max}$

1000  2000

*FIG.2C*

K

$L_{batt}$

z

$K_{min}$  $K_{min}$

1000  2000

P

c

a

1200

1201

e

*FIG.2B*

## FIG.3

## FIG.4

## FIG.6

## FIG.7

*FIG.5A*

*FIG.5B*

*FIG.5C*

12

## FIG.8

1000

1200

2000

X

Z

Y

## FIG.9A

$\Delta\alpha.1$

$\times$

0,0346

$\times$

$\times$

$\times$

0

$\Delta\beta.1$

## FIG.9B

$\Delta\alpha.1$

$\times$

$\times$

$\times$

$\times$

0,341

$\times$

0

$\Delta\beta.1$